# EUROPEAN PATENT SPECIFICATION

(11) **EP 2 557 596 B1**
(45) Date of publication and mention of the grant of the patent: **06.09.2017**
(21) Application number: 12178549.7
(22) Date of filing: 30.07.2012
(51) Int. Cl.: H01L 27/12

(54) **Display device**
Anzeigevorrichtung
Dispositif d'affichage

(30) Priority: 10.08.2011 KR 20110079673
(43) Date of publication of application: 13.02.2013
(73) Proprietor: Samsung Display Co., Ltd., Gyeonggi-do (KR)
(72) Inventor: Lee, Jae-Seob, Yongin-City Gyeonggi-Do (KR); Jeong, Chang-Yong, Yongin-City Gyeonggi-Do (KR); Park, Yong-Hwan, Yongin-City Gyeonggi-Do (KR); Kwon, Kyung-Mi, Yongin-City Gyeonggi-Do (KR)
(74) Representative: Mounteney, Simon James

(56) References cited:
- US-A1- 2003 108 749
- US-A1- 2009 032 096
- US-A1- 2009 189 204
- US-B1- 6 436 739

## Description

### BACKGROUND

### 1. Field

The present invention relates generally to a display device. More particularly, the invention relates to a display device using a base film including plastic.

### 2. Description of Related Art

Recently, flexible flat display devices, which are lightweight and resistant to impact, have been developed by utilizing a base film made of a material such as plastic.

Different flexible flat display devices may include, for example, organic light emitting diode display elements, liquid crystal display elements, and electrophoretic display (EPD) elements, among others.

In addition, flexible flat display devices may include thin film transistors (TFTs). With advantages such as having good carrier mobility, a low temperature polysilicon (LTPS) TFT can be applicable to a high speed operational circuit and can be used for a CMOS circuit, so LTPS TFTS are commonly utilized from among various types of thin film transistors.

The LTPS TFT includes a polysilicon layer formed by crystallizing an amorphous silicon layer. Methods for crystallizing the amorphous silicon layer include, for example, solid phase crystallization, excimer laser crystallization, and crystallization using a metal catalyst. The excimer laser crystallization method has been widely used because it allows for low temperature processes, so that a thermal effect on a substrate is relatively low and a polysilicon layer having relatively excellent carrier mobility over 100cm2/Vs can be made.

However, when the crystallization process is performed using a laser on a base film made of plastic, laser beams passed through the polysilicon layer are partially absorbed by the base film, thereby causing deterioration of the base film. Such a deterioration of the base film not only causes a negative effect on product reliability, but also causes failures such as separation of the base film. US2009/032096-A1 discloses a thin film device.

The above information disclosed in this Background section is only for enhancement of understanding of the background of the described technology, and therefore, it may contain information that does not form the prior art that is already known in this country to a person of ordinary skill in the art.

### SUMMARY OF THE INVENTION

The present invention seeks to provide a display device that can stably form an active layer crystallized using a laser on a base film including a material such as plastic.

A display device according the invention therefore includes: a base film including plastic; an active layer of a thin film transistor on the base film, the active layer including a polysilicon layer formed by crystallizing an amorphous silicon layer using a laser; a barrier layer between the active layer and the base film; a laser absorption layer between the barrier layer and the active layer and a buffer layer between the laser absorption layer and the active layer, wherein an amorphous silicon layer is used as the laser absorption layer and the amorphous silicon layer used as the laser absorption layer is partially crystallized while absorbing laser beams from the laser.

The barrier layer may include a plurality of inorganic layers.

The display device includes a buffer layer between the laser absorption layer and the active layer.

The laser absorption layer includes an amorphous silicon layer.

The active layer may be crystallized through excimer laser annealing (ELA).

The base film may include a material including polyimide.

The barrier layer may include a structure in which silicon oxide layers and silicon nitride layers are alternately layered.

The buffer layer may include at least one of a tetra ethyl ortho silicate (TEOS) layer, a silicon nitride layer, a silicon oxide layer, and a silicon oxynitride layer.

The base film, the barrier layer, the laser absorption layer, and the active layer may be flexible.

A display device according to another embodiment includes: a barrier layer including a plurality of inorganic layers; and the laser absorption layer is between two of the plurality of inorganic layers.

The display device may further include a buffer layer between the barrier layer and the active layer.

According to embodiments of the present invention, a display can have a stably formed active layer crystallized using a laser on a base film including a material such as plastic.

At lest some of the above and other features of the invention are set out in the claims.

### BRIEF DESCRIPTION OF THE DRAWINGS

FIG. 1 is a cross-sectional view of a display device according to a first embodiment of the invention;
FIG. 2 is an enlarged cross-sectional view of a portion of FIG. 1;
FIG. 3 is a cross-sectional view of a display device according to a second embodiment of the invention; and
FIG. 4 is an enlarged cross-sectional view of a portion of FIG. 3.

### DETAILED DESCRIPTION

The present invention will be described more fully hereinafter with reference to the accompanying drawings, in which certain embodiments of the invention are shown. As those skilled in the art will recognize, the described embodiments may be modified in various different ways without departing from the scope of the present invention.

Elements having the same or similar structures throughout the embodiments are denoted by the same reference numerals and are described in detail for a first embodiment. In subsequent embodiments, only the elements other than the same or similar elements will be described.

The drawings are schematic and not proportionally scaled. Relative scales and ratios in the drawings are enlarged or reduced for the purpose of convenience, and the scales may be random and the invention should not be limited thereto. In addition, it will be understood that when an element is referred to as being "on" another element, it can be directly on the other element, or one or more intervening elements may be present therebetween.

The embodiments described include details that are not essential to the invention. Therefore, various modifications from them are to be expected. Accordingly, the scope of the invention should not be limited to the specific shapes of shown regions, and may for example, also include modifications or variations in the shapes by manufacturing.

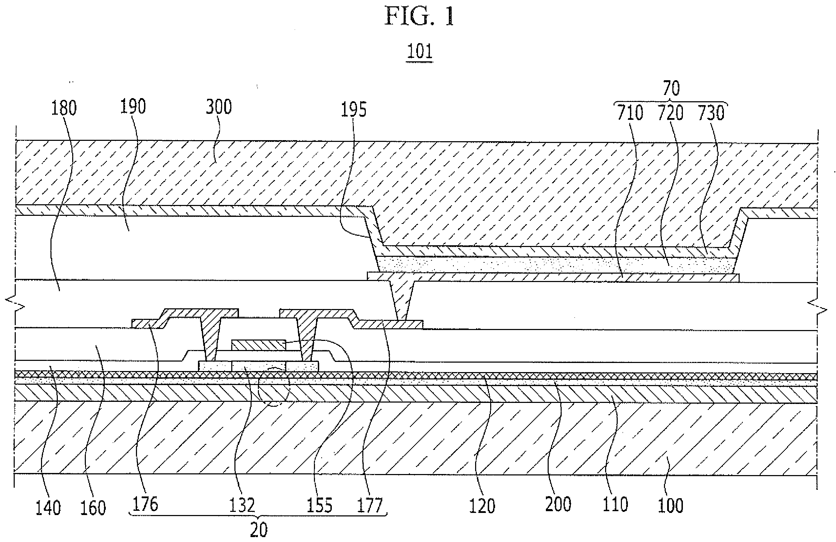

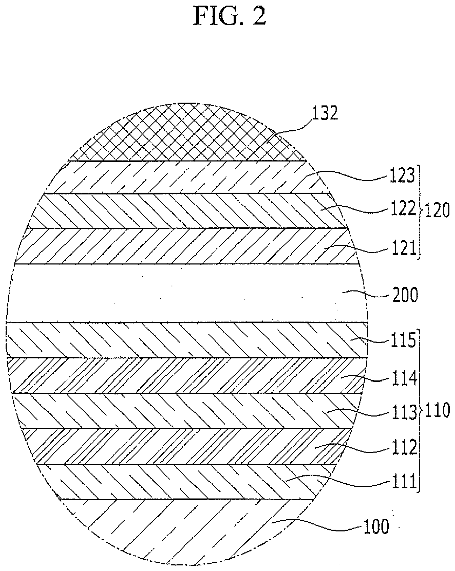

Hereinafter, a display device 101 according to a first embodiment of the invention will be described with reference to FIG. 1 and FIG. 2.

As shown in FIG. 1, the display device 101 according to this first embodiment includes a base film 100, a barrier layer 110, a laser absorption layer 200, a thin film transistor 20, and an organic light emitting element 70.

The thin film transistor 20 includes an active layer 132, a gate electrode 155, a source electrode 176, and a drain electrode 177. In this embodiment, the thin film transistor 20 has a top gate structure in which the gate electrode 155 is disposed on the active layer 132.

The active layer 132 includes a polysilicon layer crystallized from an amorphous silicon layer using a laser. The crystallization method using a laser may be, for example, an excimer laser annealing (ELA) method in particular.

In addition, the display device 101 further includes a gate insulating layer 140 for insulating the active layer 132 of the thin film transistor 20 from the gate electrode 155 and an interlayer insulating layer 160 for insulating the gate electrode 155 from the source electrode 176 and the drain electrode 177.

The organic light emitting element 70 includes a pixel electrode 710 connected to the drain electrode 177 of the thin film transistor 20, an organic emission layer 720 on the pixel electrode 710, and a common electrode 730 on the organic emission layer 720. Here, the pixel electrode 710 is a positive (+) electrode, which is a hole injection electrode and the common electrode 730 is a negative (-) electrode, which is an electron injection electrode. However, the invention is not limited thereto, and for example, the pixel electrode 710 may be the negative electrode and the common electrode 730 may be the positive electrode, according to a particular driving method of the display device 101.

Holes from the pixel electrode 710 and electrons from the common electrode 730 are injected into the organic emission layer 720, and light emission occurs when excitons, which are combinations of holes and electrons, drop from an excited state to a ground state.

The display device 101 further includes a pixel defining layer 190 having an opening 195 exposing the pixel electrode 710 to define a light emission area. The organic emission layer 720 is positioned on the pixel electrode 710 in the opening 195 of the pixel defining layer 190.

In addition, the display device 101 further includes an additional insulating layer 180 for insulating the pixel electrode 710 from the source electrode 176. The additional insulating layer 180 in this case has a planarization or planarizing characteristic, so that it can make the organic emission layer 720 substantially uniformly disposed on the pixel electrode 710.

Further, in the display device 101 according to this embodiment, the structure of the organic light emitting element 70 and the thin film transistor 20 are not limited to the structures shown in FIG. 2. The structures of the organic light emitting element 70 and the thin film transistor 20 may be changed in a variety of ways and can be easily modified by a person skilled in the art.

The base film 100 is made of or includes a plastic. Particularly, the base film 100 may be made of polyimide having excellent heat resistance, chemical resistance, durability, and electric insulation. However, the invention is not limited thereto, and the base film 100 may be made of, for example, polyethylene etherphtalate, polyethylene naphthalate, polycarbonate, polyarylate, polyetherimide, or polyethersulfone.

The barrier layer 110 prevents permeation of moisture or oxygen. The base film 100 made of plastic is more permeable to moisture or oxygen than a substrate made of glass. Thus, the barrier layer 110 is positioned on the base film 100 to prevent or reduce moisture or oxygen from permeating past the base film 100 and negatively affecting the organic light emitting element 70 on the base film 100.

As shown in FIG. 2, the barrier layer 110 includes a plurality of inorganic layers 111, 112, 113, 114, and 115. Particularly, the barrier layer 110 has a structure in which silicon oxide layers 111, 113, and 115 and silicon nitride layers 112 and 114 are alternately stacked. However, the invention is not limited thereto, and the barrier layer 110 may include various different types of inorganic layers.

A laser absorption layer 200 prevents or reduces parts of laser beams radiated during a process of forming the active layer 132 of the thin film transistor 20 from passing through the barrier layer 110 toward the base film 100. If the laser beams reach the base film 100, the laser beams can be absorbed by the base film 100, which may deteriorate the base film 100. Therefore, the laser absorption layer 200 prevents the laser beams from reaching the base film 100 by absorbing the laser beams moving toward the base film 100.

An amorphous silicon layer is used as the laser absorption layer 200. The amorphous silicon layer used as the laser absorption layer 200 is partially crystallized while absorbing the laser beams.

The buffer layer 120 is arranged on the laser absorption layer 200. The buffer layer 120 includes at least one of a tetra ethyl ortho silicate (TEOS) layer, a silicon nitride layer, a silicon oxide layer, or a silicon oxynitride layer. FIG. 2 illustrates a tri-layered buffer layer 120 that includes a silicon nitride layer 121, a silicon oxide layer 122, and a TEOS layer 123.

The buffer layer 120 additionally blocks moisture or oxygen that passed through the barrier layer 110, and also planarizes the surface to stably form the active layer 132.

The active layer 132 of the thin film transistor 20 is disposed on the buffer layer 120. As described above, the active layer 132 is formed by patterning the polysilicon layer that is formed by crystallizing the amorphous silicon layer using a laser.

In addition, as shown in FIG. 1, the display device 101 may further include a thin film encapsulation layer 300 covering the organic light emitting element 70. The thin film encapsulation layer 300 may have a structure in which at least one of a plurality of inorganic layers and at least one of a plurality of organic layers are layered. Like the base film 100 and the barrier layer 110, the thin film encapsulation layer 300 prevents or reduces permeation of moisture or oxygen into the organic light emitting element 70 while protecting the organic light emitting element 70.

In addition, the display device 101 is not limited to an organic light emitting diode display. Thus, embodiments of the invention can be applied to any display device that includes a thin film transistor using a polysilicon layer crystallized by a laser. Such display devices include, for example, liquid crystal displays and electrophoretic display (EPD) devices.

With such a configuration, the display device 101 according to this embodiment of the invention can stably form an active layer 132 crystallized using a laser, on a base film 100 made of or including plastic. That is, separation of the base film 100 from a barrier layer 110 caused by deterioration of the base film 100 due to the laser beams during the forming of the active layer 132 can be effectively prevented or reduced.

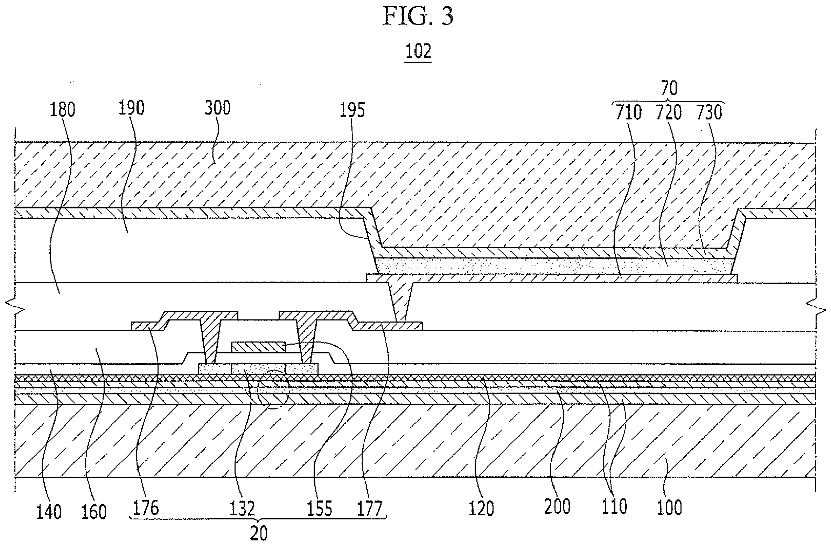

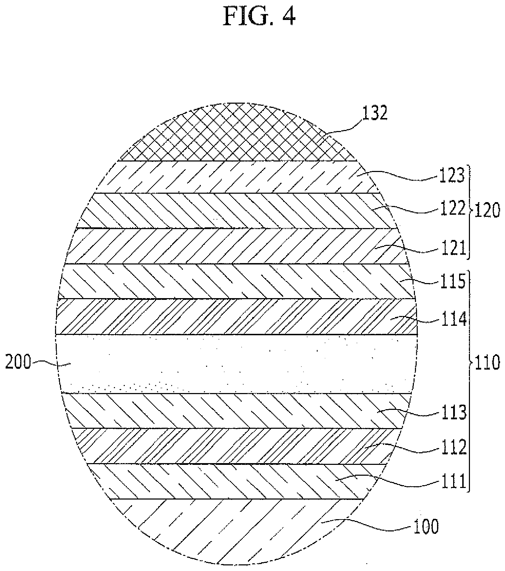

Hereinafter, a display device 102 according to a second embodiment of the invention will be described with reference to FIG. 3 and FIG. 4.

As shown in FIG. 3, in the display device 102 according to this embodiment, a laser absorption layer 200 is disposed in the middle of a barrier layer 110.

Particularly, as shown in FIG. 4, the laser absorption layer 200 is positioned between a plurality of inorganic layers 111, 112, 113, 114, and 115 of the barrier layer 110. The barrier layer 110 includes silicon oxide layers 111, 113, and 115 and silicon nitride layers 112 and 114 that are alternately stacked, and the laser absorption layer 200 may be positioned in at least one space between the silicon oxide layers 111, 113, and 115 the silicon nitride layers 112 and 114.

With such a configuration, the display device 102 according to this second embodiment can also stably form the active layer 132 crystallized using a laser beam, on a base film 100 made of or including plastic. That is, separation of the base film 100 from the barrier layer 110 caused by deterioration of the base film 100 due to the laser beams during the forming of the active layer 132 can be effectively prevented or reduced.

While the invention has been described in connection with what are presently considered to be practical embodiments, it is to be understood that the invention is not limited to the disclosed embodiments, but is instead defined by the appended claims.

## Claims

1. A display device comprising:
a base film (100) comprising plastic;
an active layer (132) of a thin film transistor on the base film, the active layer comprising a polysilicon layer formed by crystallizing an amorphous silicon layer using a laser;
a barrier layer (110) between the active layer and the base film;
a laser absorption layer (200) located between at least a part of the barrier layer and the active layer;
and a buffer layer (120) between the laser absorption layer and the active layer, wherein an amorphous silicon layer is used as the laser absorption layer and the amorphous silicon layer used as the laser absorption layer is partially crystallized while absorbing laser beams from the laser.

2. A display device according to claim 1, wherein the barrier layer comprises a plurality of inorganic layers.

3. A display device according to any preceding claim, wherein the active layer is crystallized through excimer laser annealing (ELA).

4. A display device according to any preceding claim, wherein the base film comprises a material including polyimide.

5. A display device according to any preceding claim, wherein the barrier layer comprises a structure in which silicon oxide layers and silicon nitride layers are alternately stacked.

6. A display device according to any preceding claim, wherein the buffer layer comprises at least one of a tetra ethyl ortho silicate (TEOS) layer, a silicon nitride layer, a silicon oxide layer, or a silicon oxynitride layer.

7. A display device according to any preceding claim, wherein the base film, the barrier layer, the laser absorption layer, and the active layer are flexible.

8. A display device according to claim 1, wherein the barrier layer comprises a plurality of inorganic layers; and
the laser absorption layer is situated between two of the plurality of inorganic layers.

9. A display device according to claim 8, further comprising a buffer layer between the barrier layer and the active layer.

## Patentansprüche

1. Bildschirmvorrichtung, aufweisend:
einen Basisfilm (100), der Kunststoff enthält;
eine aktive Schicht (132) eines Dünnfilmtransistors auf dem Basisfilm, wobei die aktive Schicht eine Polysiliziumschicht aufweist, die durch Kristallisation einer amorphen Siliziumschicht mittels eines Lasers gebildet ist;
eine Sperrschicht (110) zwischen der aktiven Schicht und dem Basisfilm;
eine Laserabsorptionsschicht (200), die zwischen wenigstens einem Teil der Sperrschicht und der aktiven Schicht angeordnet ist;
und eine Pufferschicht (120) zwischen der Laserabsorptionsschicht und der aktiven Schicht,
wobei eine amorphe Siliziumschicht als die Laserabsorptionsschicht verwendet wird, und die amorphe Siliziumschicht, die als die Laserabsorptionsschicht verwendet wird, teilweise kristallisiert wird, während sie Laserstrahlen von dem Laser absorbiert.

2. Bildschirmvorrichtung nach Anspruch 1, wobei die Sperrschicht mehrere anorganische Schichten enthält.

3. Bildschirmvorrichtung nach einem beliebigen der vorhergehenden Ansprüche, wobei die aktive Schicht durch Excimerlasertempern (Excimer Laser Annealing, ELA) kristallisiert wird.

4. Bildschirmvorrichtung nach einem beliebigen der vorhergehenden Ansprüche, wobei der Basisfilm auf einem Material basiert, das Polyimid aufweist.

5. Bildschirmvorrichtung nach einem beliebigen der vorhergehenden Ansprüche, wobei die Sperrschicht eine Struktur aufweist, in der abwechselnd Siliziumoxidschichten und Siliziumnitridschichten gestapelt sind.

6. Bildschirmvorrichtung nach einem beliebigen der vorhergehenden Ansprüche, wobei die Pufferschicht wenigstens eines von einer Tetraethylorthosilikat(TEOS)-Schicht, einer Siliziumnitridschicht, einer Siliziumoxidschicht oder einer Siliziumoxinitridschicht enthält.

7. Bildschirmvorrichtung nach einem beliebigen der vorhergehenden Ansprüche, wobei der Basisfilm, die Sperrschicht, die Laserabsorptionsschicht und die aktive Schicht flexibel sind.

8. Bildschirmvorrichtung nach Anspruch 1, wobei die Sperrschicht mehrere anorganische Schichten enthält; und
die Laserabsorptionsschicht zwischen zwei der mehreren anorganischen Schichten angeordnet ist.

9. Bildschirmvorrichtung nach Anspruch 8, ferner mit einer Pufferschicht zwischen der Sperrschicht und der aktiven Schicht.

## Revendications

1. Dispositif d'affichage comprenant :
un film de base (100) comprenant une matière plastique ;
une couche active (132) d'un transistor à couches minces sur le film de base, la couche active comprenant une couche de polysilicium formée en cristallisant une couche de silicium amorphe en utilisant un laser ;
une couche de barrière (110) entre la couche active et le film de base ;
une couche d'absorption de laser (200) située entre au moins une partie de la couche de barrière et la couche active ;
et une couche tampon (120) entre la couche d'absorption de laser et la couche active,
dans lequel une couche de silicium amorphe est utilisée en tant que couche d'absorption de laser et la couche de silicium amorphe utilisée en tant que couche d'absorption de laser est partiellement cristallisée tandis qu'elle absorbe les faisceaux lasers provenant du laser.

2. Dispositif d'affichage selon la revendication 1, dans lequel la couche de barrière comprend une pluralité de couches inorganiques.

3. Dispositif d'affichage selon l'une quelconque des revendications précédentes, dans lequel la couche active est cristallisée par recuit au laser à excimère (ELA).

4. Dispositif d'affichage selon l'une quelconque des revendications précédentes, dans lequel le film de base comprend un matériau comprenant du polyimide.

5. Dispositif d'affichage selon l'une quelconque des revendications précédentes, dans lequel la couche de barrière comprend une structure dans laquelle des couches d'oxyde de silicium et des couches de nitrure de silicium sont empilées alternativement.

6. Dispositif d'affichage selon l'une quelconque des revendications précédentes, dans lequel la couche tampon comprend au moins l'une d'une couche d'orthosilicate de tétraéthyle (TEOS), d'une couche de nitrure de silicium, d'une couche d'oxyde de silicium, ou d'une couche d'oxynitrure de silicium.

7. Dispositif d'affichage selon l'une quelconque des revendications précédentes, dans lequel le film de base, la couche de barrière, la couche d'absorption de laser et la couche active sont flexibles.

8. Dispositif d'affichage selon la revendication 1, dans lequel la couche de barrière comprend une pluralité de couches inorganiques ; et
la couche d'absorption de laser est située entre deux couches de la pluralité de couches inorganiques.

9. Dispositif d'affichage selon la revendication 8, comprenant en outre une couche tampon entre la couche de barrière et la couche active.
